# EUROPÄISCHE PATENTSCHRIFT

(11) **EP 0 543 037 B1**
(45) Veröffentlichungstag und Bekanntmachung des Hinweises auf die Patenterteilung: **13.09.1995**
(21) Anmeldenummer: 91119773.9
(22) Anmeldetag: 19.11.1991
(51) Int. Cl.: G05B 19/04, H03K 19/0175

(54) **In einen integrierten Schaltkreis integrierte parametrierbare Ausgabeschaltung**
Output circuit with adjustable parameters in an integrated circuit
Circuit de sortie intégré et paramétrable dans un circuit intégré

(43) Veröffentlichungstag der Anmeldung: 26.05.1993
(73) Patentinhaber: SIEMENS AKTIENGESELLSCHAFT, 80333 München (DE)
(72) Erfinder: Roman, Wagner, Dipl.-Ing., W-8450 Amberg (DE)

(56) Entgegenhaltungen:
- EP-A- 0 281 416
- IBM TECHNICAL DISCLOSURE BULLETIN Bd. 32, Nr. 12, 12. Mai 1990, Seiten 211 - 212; 'SELECTABLE FULL OR PARTIAL SWING OUTPUT LEVEL CONVERTER'
- DATA CONVERSION SEMINAR, ANALOG DEVICES INC, 1984, Boston, US.

## Beschreibung

### Integrierter Schaltkreis mit einer integrierten parametrierbaren Ausgabeschaltung

Die vorliegende Erfindung betrifft einen integrierten Schaltkreis mit einer elektronischen Ausgabeschaltung zur Ausgabe von elektrischen Signalen, vorzugsweise Analogsignalen.

Aus dem Data Conversion Seminar von Analog Devices Inc., Seiten 1.38-40, 1984, ist ein derartiger integrierter Schaltkreis mit einem Analogschaltkreis bekannt, bei dem der Signalpegelbereich mittels einer einzuspeisenden Referenzspannung variierbar ist.

Analogausgabeschaltungen sind beispielsweise auch aus Analog-Ausgabebaugruppen für modulare speicherprogrammierbare Steuerungen bekannt.

Derartige Baugruppen weisen üblicherweise Schaltungen auf, deren Signalart und Signalpegelbereich vorab festgelegt sind. Eine auf der Baugruppe angeordnete Schaltung gibt beispielsweise ein Spannungsignal zwischen 0 und +10 V aus. Eine andere Schaltung gibt beispielsweise ein Stromsignal zwischen + und -20mA aus.

Die Nachteile einer derart starren Zuordnung von Signalpegeln zu einzelnen Schaltungen sind vielfältig. Zum einen besteht die Gefahr von Fehlverdrahtungen. Zum anderen besteht die Notwendigkeit zu vergrößerter Ersatzteilhaltung. Zum dritten können prinzipiell vorhandene Ausgabekanäle nicht genutzt werden, weil sie ein Signal liefern, das im jeweiligen Anwendungsfall ungeeignet ist.

Aus dem IMB Technical Disclosure Bulletin, Band 32, Nr. 12, vom Mai 1990, Seiten 211 und 212, ist eine Digital-Ausgabeschaltung bekannt, die über einen Auswahleingang parametrierbar ist. Je nach Parametrierung kann der Ausgang entweder einen der zwei Werte "Versorgungsspannung" bzw. "Masse" oder aber die Pegel "0,8 Volt über Masse" und "0,8 Volt unter Versorgungsspannung" liefern.

Die Aufgabe der vorliegenden Erfindung besteht darin, dem Anwender eine kostengünstige Schaltung zur Verfügung zu stellen, die flexibel an die jeweiligen Anforderungen angepaßt werden kann.

Die Aufgabe wird durch das Kennzeichen des Anspruchs 1 gelöst.

Vorzugsweise ist zumindest der andere Wert einer Auswerteschaltung zur Überwachung der Ausgabesignalleitung auf Leitungsfehler, z. B. Drahtbruch oder Kurzschluß, zugeführt.

Wenn der Schaltkreis eine externe Zusatzbeschaltung zur Signalpegelbereichsanpassung aufweist, muß der Schaltkreis nicht für Spannungen bis mindestens 10 V ausgelegt sein. Es genügt eine Versorgung mit erheblich geringerer Spannung.

Der Schaltkreis weist vorzugsweise mehrere Ausgabeschaltungen auf, die aus Kostengründen über einen gemeinsamen DigitalAnalog-Wandler, vorzugsweise im Zeitmultiplex, mit Soll-Ausgabesignalen beaufschlagt werden. So ist eine hohe Integrationsdichte zu erzielen.

Wenn der Schaltkreis einen Logikblock zum Ansteuern und Überwachen der Ausgabeschaltungen sowie zur Kommunikation mit einer dem integrierten Schaltkreis übergeordneten Zentraleinheit aufweist, wird die übergeordnete Zentraleinheit von Überwachungsaufgaben entlastet.

Weitere Vorteile und Einzelheiten ergeben sich aus der nachfolgenden Beschreibung eines Ausführungsbeispiels. Es Zeigen:
FIG 1 ein Blockschaltbild einer Analog-Ausgabebaugruppe und
FIG 2 eine Analog-Ausgabeschaltung.

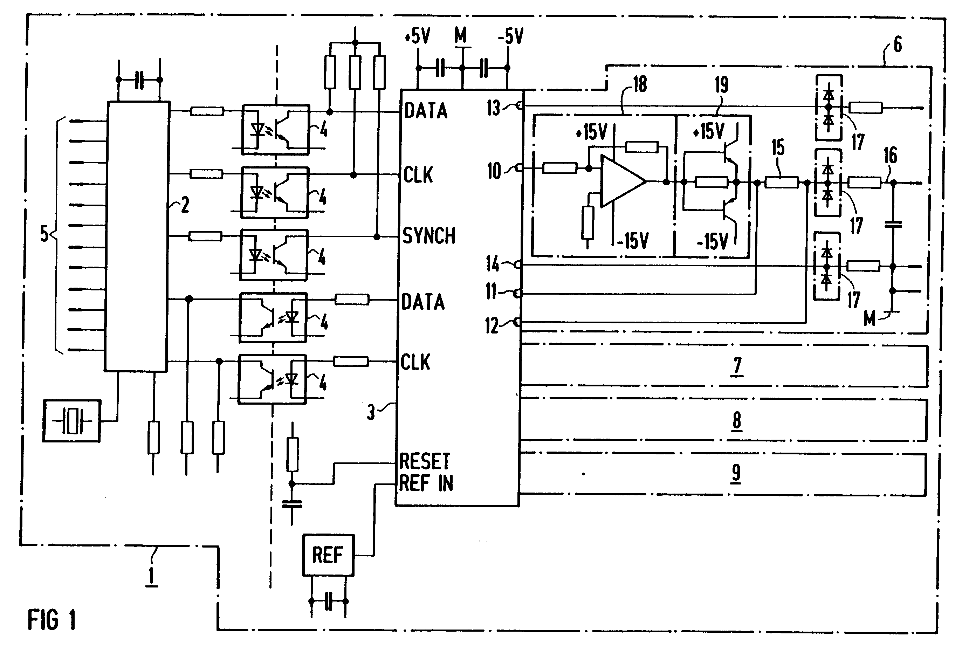

Gemäß FIG 1 weist eine Analog-Ausgabebaugruppe 1 zwei anwendungsspezifische Schaltkreise 2, 3 auf, die über Optokoppler 4 miteinander gekoppelt, galvanisch aber getrennt sind. Der Schaltkreis 2 ist ein Schnittstellenschaltkreis, der mit dem Bus 5 eines Automatisierungsgerätes verbunden ist. Über diesem Bus 5 werden Daten zwischen dem Ausgabeschaltkreis 3 und einer nicht dargestellten übergeordneten Zentraleinheit ausgetauscht. Im Schnittstellenschaltkreis 2 findet dabei beispielsweise eine Parallel-Seriell-Umsetzung statt, gegebenenfalls auch die Umsetzung auf eine Standardschnittstelle.

Der Ausgabeschaltkreis 3 dient der Ausgabe von Analogsignalen an nicht dargestellte Stellglieder. Er ist in CMOS-Technologie hergestellt. Dadurch können die internen Verluste auf ein Minimum begrenzt bleiben. Weiterhin ist der Schaltkreis 3 nur an die Versorgungsspannungen +5 V, -5 V und Masse M angeschlossen. Der Schaltkreis 3 kann damit als maximales Ausgangssignal selbstverständlich ebenfalls maximal +/-5 V liefern. Die Verstärkung auf Spannungen bis +/-10 V erfolgt durch eine externe Zusatzbeschaltung 18, 19, die später noch erläutert werden wird. Mittels dieser Zusatzbeschaltung 18, 19 werden die Ausgangssignale des Schaltkreises 3 auf das benötigte Spannungsniveau verstärkt und auch mit entsprechend hohen Stromstärken getrieben.

Gemäß FIG 1 weist der Ausgabeschaltkreis 3 vier Ausgabekanäle 6 bis 9 auf. Dabei sind die Ausgabekanäle 7 bis 9 der Übersichtlichkeit halber nur schematisiert dargestellt. Jeder Ausgabekanal weist fünf Anschlüsse 10 bis 14 auf, die wie folgt belegt sind:
- Über den Ausgabeanschluß 10 wird das aktuelle Ausgangssignal des Kanals ausgegeben.
- Mittels der Stromrückführanschlüsse 11 und 12 wird die Spannung gemessen, die über dem Widerstand 15 abfällt. Da die über dem Widerstand 15 abfallende Spannung proportional zum Strom I durch den Widerstand 15 und damit dem Strom I in der Ausgabeleitung 16 ist, kann somit indirekt der in der Ausgabeleitung 16 fließende Strom I bestimmt werden. Damit die Messung möglichst genau ist, wird als Widerstand 15 vorzugsweise ein Präzisionswiderstand verwendet.
- Mittels des Spannungsrückführanschlusses 13 wird die an der nicht dargestellten Last anliegende Spannung U gemessen.
- Mittels des Masserückführanschlusses 14 wird das momentane Masseniveau der Last gemessen.

Die in FIG 1 dargestellten Diodenbrücken 17 bilden eine Schutzstruktur und dienen der Unterdrückung von Überspannungen. Sie sind in Sperrichtung geschaltet und an die Versorgung, hier +15 V und -15 V, angeschlossen.

Zur Reduzierung der Anzahl der benötigen Anschlüsse können gegebenenfalls die Anschlüsse 12 und 13 zusammengefaßt werden sowie der Anschluß 14 entfallen. In diesem Fall ergibt sich zwar eine verringerte Meßgenauigkeit, diese kann jedoch im Einzelfall tolerierbar sein.

Wie obenstehend erwähnt, wird der Ausgabeschaltkreis 3 nur mit Spannungen zwischen + und -5 V versorgt. Auch seine Ausgangssignale können daher nicht außerhalb dieses Spannungsbereiches liegen. Die Ausgangsspannung am Ausgabeanschluß 10 wird folglich mittels der an sich bekannten Verstärkerschaltung 18 verstärkt. Dadurch wird erreicht, daß die Ausgabeleitung 16 mit Spannungen zwischen + und -10 V beaufschlagbar ist.

Hinter der Verstärkerschaltung 18 ist eine ebenfalls an sich bekannte Treiberschaltung 19 angeordnet. Mittels der Treiberschaltung 19 ist es möglich, die Ausgabeleitung 16 mit dem benötigten Strom I zu versorgen, ohne daß die Spannung U, mit der die Leitung 16 beaufschlagt wird, absinkt.

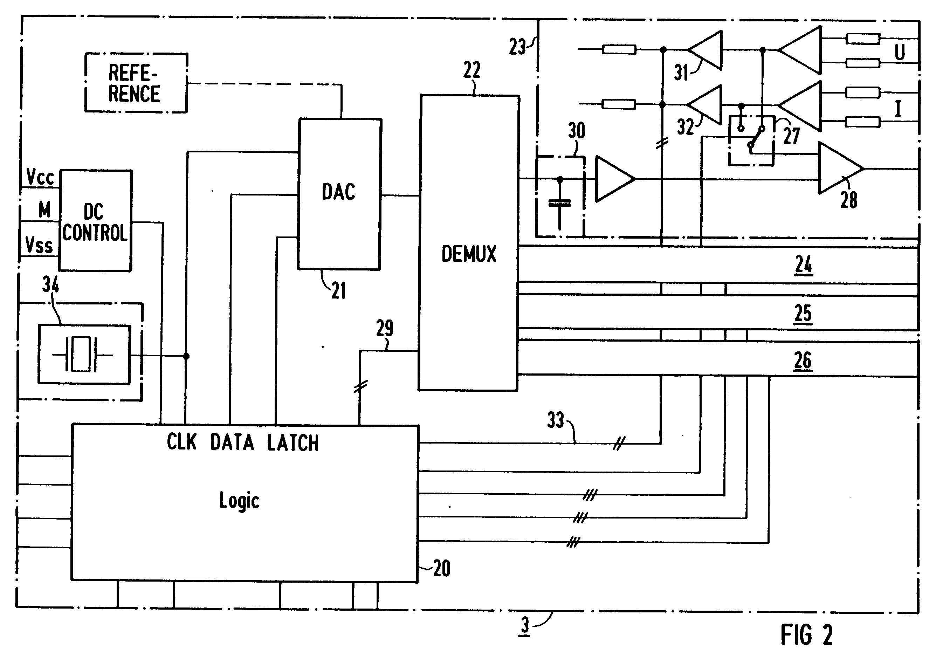

Die FIG 2 zeigt den internen Aufbau des Ausgabeschaltkreises 3. Gemäß Fig. 2 besteht der Ausgabeschaltkreis 3 im wesentlichen aus einem Logikblock 20, einem Digital-Analog-Wandler 21, einem Demultiplexer 22 und vier Ausgabeschaltungen 23 bis 26. Von den Ausgabeschaltungen 23 bis 26 ist der Übersichtlichkeit halber nur die Schaltung 23 im einzelnen dargestellt. Der Logikblock 20 nimmt innerhalb des Ausgabeschaltkreises 3 mehrere Funktionen ein. Zum einen erfolgt über den Logikblock 20 die Kommunikation zwischen der nicht dargestellten Zentraleinheit und dem Ausgabeschaltkreis 3. Zum anderen speichert der Logikblock 20 von der Zentraleinheit übermittelte Kommandos und Parameter ab. Zum dritten übernimmt der Logikblock 20 die Ansteuerung der Ausgabeschaltungen 23 bis 26. Weiterhin überwacht der Logikblock 20 die Funktion der Ausgabeschaltungen 23 bis 26.

Bei Inbetriebnahme der Ausgabebaugruppe 1 bzw. nach einem Reset wird der Ausgabeschaltkreis 3 stets neu parametriert. Dem Ausgabeschaltkreis 3 wird dazu von der Zentraleinheit mitgeteilt, welche der vier Ausgabeschaltungen 23 bis 26 überhaupt mit Ausgangssignalen beaufschlagt werden sollen, ob ein Spannungs- oder ein Stromsignal ausgegeben werden soll sowie welches der jeweils einzustellende Signalpegelbereich ist. Diese Parameter werden in einem nicht dargestellten Parameterregister des Logikblockes 20 abgespeichert.

Die Nichtaktivierung einzelner Ausgabeschaltungen 23 bis 26 geschieht dadurch, daß diese beim zyklischen Versorgen der Ausgabeschaltungen 23 bis 26 mit auszugebenden Signalen nicht berücksichtigt werden. Die Einstellung der Signalart, also Strom- oder Spannungsausgabe, erfolgt über den Schalter 27. Je nachdem, ob das Strom- oder das Spannungssignal in den Regler 28 rückgekoppelt wird, wirkt die jeweilige Ausgabeschaltung als Strom- oder Spannungsausgabeschaltung. Die Signalpegelbereichsanpassung erfolgt innerhalb des Logikblockes 20 durch entsprechendes Umsetzen des zuletzt übermittelten Digitalsignales in den dem angewählten Signalpegelbereich entsprechenden Wert. Die Spannungsbereiche sind im vorliegenden Fall 0 bis 10 V und -10 V bis +10 V. Die Strombereiche sind 4 bis 20 mA und -20 mA bis +20 mA. Es sind aber selbstverständlich auch andere Spannungsbereiche oder Strombereiche, z.B. 0 bis 1 V oder -1 V bis 1 V, denkbar.

Die zuletzt übermittelten Werte für die einzelnen Ausgabekanäle werden zyklisch aus Registern des Logikblockes 20 abgerufen. Sie werden vom Logikblock 20 entsprechend der gewählten Signalart und dem gewählten Signalpegelbereich in einen neuen Digitalwert umgesetzt und dann an den Digital-Analog-Wandler 21 übermittelt. Dieser setzt den Digitalwert in einen Analogwert um. Er übermittelt den Analogwert weiter an den Demultiplexer 22, der nacheinander gemäß dem über die Leitung 29 übermittelten Signal die Sample-and-Hold-Schaltung 30 einer der Ausgabeschaltungen 23 bis 26 mit dem auszugebenden Analogsignal beaufschlagt. Von dort werden die Signale dem Regler 28 als Sollwerte zugeleitet. Um das ausgegebene Signal auf seinem Sollwert zu stabilisieren, weist der Verstärker einen Integralanteil auf, ist also als PI- oder PID-Regler ausgebildet.

Statt der oben beschriebenen Ausgestaltung, bei der ein einziger Digital-Analog-Wandler 21 verwendet wird, kann auch ein Shaltkreis 3 verwendet werden, der für jede Ausgabeschaltung 23 bis 26 einen eigenen Digital-Analog-Wandler 21 aufweist.

Sowohl das gemessene Spannungssignal U als auch das gemessene Stromsignal I werden Fensterkomparatoren 31, 32 zugeleitet. Wenn die Schaltung 23 als Spannungsausgabeschaltung wirkt und der Strom I einen gewissen, voreingestellten Wert überschreitet, wird dies dem Logikblock 20 über die Leitung 33 gemeldet. Der Logikblock 20 interpretiert dieses Signal als Meldung eines Kurzschlusses auf der Ausgabeleitung 16. In analoger Weise wird ein Drahtbruch erkannt, wenn die Schaltung 23 als Stromausgabeschaltung wirkt und die Spannung U einen vorbestimmten Pegel überschreitet.

In beiden Fällen wird der betreffende Kanal deaktiviert und eine Fehlermeldung an die Zentraleinheit gemeldet. Die Zentraleinheit kann dann eine Fehlermeldung an den Benutzer ausgeben.

Falls die gemessenen Strom- und Spannungssignale verrauscht sind, kann gegebenenfalls eine Glättung innerhalb und/oder außerhalb des Ausgabeschaltkreises erforderlich sein.

Die vorstehend beschriebene Erfindung ist vorzugsweise bei Analog-Ausgabegruppen anwendbar. Sie ist prinzipiell aber auch bei Digital-Ausgabegruppen anwendbar. In diesem Falle kann selbstverständlich der Digital-Analog-Wandler 21 entfallen.

## Patentansprüche

1. Integrierter Schaltkreis (3) mit mindestens einer elektronischen Ausgabeschaltung (23 bis 26) zur Ausgabe von elektrischen Signalen, vorzugsweise Analog-Signalen,
**dadurch gekennzeichnet**,
- daß sie in Abhängigkeit von einem vom Benutzer vorgebbaren Signalartparameter als Spannungsausgabeschaltung oder als Stromausgabeschaltung betreibbar ist,
- daß sowohl der Stromwert (I) als auch der Spannungswert (U) der Ausgabeschaltung (23 bis 26) in die Ausgabeschaltung (23 bis 26) zurückgeführt sind und
- daß der Wert, der gerade das auszugebende Signal darstellt, zur Stabilisierung des auszugebenden Signals einer Rückkopplungsschaltung (28) zugeführt ist.

2. Integrierter Schaltkreis (3) nach Anspruch 1, **dadurch gekennzeichnet**, daß zumindest der andere Wert einer Auswerteschaltung (31,32) zur Überwachung der Ausgabesignalleitung (16) auf Leitungsfehler, z.B. Drahtbruch oder Kurzschluß, zugeführt ist.

3. Integrierter Schaltkreis (3) nach Anspruch 1 oder 2, **dadurch gekennzeichnet**, daß die Ausgabeschaltung (23 bis 26) in Abhängigkeit von einem vom Benutzer vorgebbaren Signalpegelparameter in einem von mehreren Signalpegelbereichen betreibbar ist.

4. Integrierter Schaltkreis (3) nach Anspruch 1, 2 oder 3, **dadurch gekennzeichnet**, daß die Ausgabeschaltung (23 bis 26) eine schaltkreisexterne Zusatzbeschaltung (18,19) zur Signalpegelbereichsanpassung aufweist.

5. Integrierter Schaltkreis (3) nach einem der obigen Ansprüche, **dadurch gekennzeichnet**, daß er mindestens zwei elektronische Ausgabeschaltungen (23 bis 26) zur Ausgabe von elektrischen Signalen aufweist.

6. Integrierter Schaltkreis (3) nach Anspruch 5, **dadurch gekennzeichnet**, daß die Ausgabeschaltungen (23 bis 26) über einen gemeinsamen DigitalAnalog-Wandler (21), vorzugsweise im Zeitmultiplex, mit Soll-Ausgabesignalen beaufschlagt werden.

7. Integrierter Schaltkreis (3) nach Anspruch 5, **dadurch gekennzeichnet**, daß die Ausgabeschaltungen (23 bis 26) über je einen eigenen DigitalAnalog-Wandler (21) mit Soll-Ausgabesignalen beaufschlagt werden.

8. Integrierter Schaltkreis (3) nach einem der Ansprüche 5 bis 7, **dadurch gekennzeichnet**, daß er einen Logikblock (20) zum Ansteuern und Überwachen der Ausgabeschaltungen (23 bis 26) sowie zur Kommunikation mit einer dem integrierten Schaltkreis (3) übergeordneten Zentraleinheit aufweist.

## Claims

1. Integrated circuit (3) having at least one electronic output circuit arrangement (23 to 26) for the output of electric signals, preferably analog signals, characterised
- in that the output circuit arrangement can be operated as a voltage output circuit arrangement or as a current output circuit arrangement, as a function of a signal type parameter which can be preset by the user,
- in that both the current value (I) and the voltage value (U) of the output circuit arrangement (23 to 26) are fed back into the output circuit arrangement (23 to 26), and
- in that the value which represents precisely that signal which is to be output is supplied to a feedback circuit arrangement (28) for the purpose of stabilizing the signal to be output.

2. Integrated circuit (3) according to claim 1, characterised in that at least the other value is supplied to an evaluating circuit arrangement (31, 32) for the purpose of monitoring the output signal line (16) for line faults, for example a line break or short circuit.

3. Integrated circuit (3) according to claim 1 or 2, characterised in that the output circuit arrangement (23 to 26) can be operated in one of a plurality of signal level ranges as a function of a signal level parameter which can be preset by the user.

4. Integrated circuit (3) according to claim 1, 2 or 3, characterised in that the output circuit arrangement (23 to 26) has an additional external circuit element (18, 19) for signal level range adaptation.

5. Integrated circuit (3) according to one of the above claims, characterised in that it has at least two electronic output circuit arrangements (23 to 26) for the output of electric signals.

6. Integrated circuit (3) according to claim 5, characterised in that the output circuit arrangements (23 to 26) receive rated output signals by way of a common digital-analog converter (21), preferably in time-division multiplex mode.

7. Integrated circuit (3) according to claim 5, characterised in that the output circuit arrangements (23 to 26) receive rated output signals by way of a respective particular digital-analog converter (21).

8. Integrated circuit (3) according to one of the claims 5 to 7, characterised in that it has a logic unit (20) to activate and monitor the output circuit arrangements (23 to 26) and also to communicate with a central processing unit which is higher ranking than the integrated circuit (3).

## Revendications

1. Circuit (3) intégré comportant au moins un circuit (23 à 26) électronique de sortie destiné à la fourniture de signaux électriques, notamment de signaux analogiques, caractérisé en ce que
- il peut fonctionner en fonction d'un paramètre du type de signaux, qui peut être prescrit par l'utilisateur, comme circuit de sortie de tension ou comme circuit de sortie de courant,
- à la fois la valeur (I) du courant et également la valeur (U) de la tension du circuit (23 à 26) de sortie sont renvoyées au circuit (23 à 26) de sortie, et
- la valeur, qui représente justement le signal à fournir, est envoyée, pour stabiliser le signal à fournir, au circuit (28) de rétroaction.

2. Circuit (3) intégré suivant la revendication 1, caractérisé en ce qu'au moins l'autre valeur est envoyée à un circuit (31,32) d'exploitation destiné à contrôler une erreur sur la ligne (16) du signal de sortie, par exemple une rupture d'un fil ou un court-circuit.

3. Circuit (3) intégré suivant la revendication 1 ou 2, caractérisé en ce que le circuit (23 à 26) de sortie peut fonctionner en fonction d'un paramètre de niveau du signal, qui peut être prescrit par l'utilisateur, dans un parmi plusieurs domaines de niveau du signal.

4. Circuit (3) intégré suivant la revendication 1, 2 ou 3, caractérisé en ce que le circuit (23 à 26) de sortie comporte un circuit (18,19) supplémentaire extérieur au circuit intégré et destiné à l'adaptation d'un domaine de niveau du signal.

5. Circuit (3) intégré suivant l'une des revendications précédentes, caractérisé en ce qu'il comporte au moins deux circuits électroniques (23 à 26) de sortie destinés à la fourniture de signaux électriques.

6. Circuit (3) intégré suivant la revendication 5, caractérisé en ce que les circuits (23 à 26) de sortie reçoivent par l'intermédiaire d'un convertisseur (21) commun numérique/analogique, de préférence un multiplexeur temporel, des signaux de sortie de consigne.

7. Circuit (3) intégré suivant la revendication 5, caractérisé en ce que les circuits (23 à 26) de sortie reçoivent chacun par l'intermédiaire d'un convertisseur (21) numérique-analogique, qui leur est propre, des signaux de sortie de consigne.

8. Circuit (3) intégré suivant l'une des revendications 5 à 7, caractérisé en ce qu'il comporte un bloc (20) logique destiné à la commande et au contrôle des circuits (23 à 26) de sortie ainsi qu'à la communication avec une unité centrale d'ordre supérieur au circuit (3) intégré.
